Europäisches Patentamt

European Patent Office

Office européen des brevets

(19)

(11) Publication number : **0 633 593 A1**

(12) **EUROPEAN PATENT APPLICATION**

(21) Application number : 94304816.5

(22) Date of filing : 30.06.94

(51) Int. Cl.⁶ : **H01J 1/30, H01J 37/073**

(30) Priority : 30.06.93 JP 161621/93

(43) Date of publication of application :
11.01.95 Bulletin 95/02

(84) Designated Contracting States :
**DE FR GB NL**

(71) Applicant : **HITACHI, LTD.**
**6, Kanda Surugadai 4-chome**
**Chiyoda-ku, Tokyo 100 (JP)**

(72) Inventor : **Ohshima, Takashi, Hitachi Fuchuryo**
**32-7 Nishifucho-3-chome**
**Fuchu-shi (JP)**
Inventor : **Kuroda, Katsuhiro**
**15-11 Nanyodai-2-chome**
**Hachioji-shi (JP)**

Inventor : **Mori, Mitsuhiro**
**18-5, Yakushidai-3-chome,**
**Miroyamachi**
**Kitasoma-gun, Ibaraki-ken (JP)**
Inventor : **Nakagawa, Kiyokazu**
**Sayama Nyutaun 108-2**
**3484-145 Kashiwabara, Sayama-shi (JP)**
Inventor : **Mishima, Tomoyoshi**
**12-10 Kamimuneoka-1-chome**
**Shiki-shi (JP)**
Inventor : **Hiruma, Kenji**
**6-19, Nukuiminamicho-5-chome**
**Koganei-shi (JP)**
Inventor : **Hiruma, Kenji**
**6-19, Nukuiminamicho-5-chome**
**Koganei-shi (JP)**
Inventor : **Miyao, Masanobu**
**17-1-F308 Kotesashicho-1-chome**
**Tokorozawa-shi (JP)**

(74) Representative : **Calderbank, Thomas Roger et al**
**MEWBURN ELLIS**
**York House**
**23 Kingsway**
**London WC2B 6HP (GB)**

(54) Electrom beam source and electron beam application apparatus and electronic apparatus using the same.

(57) An electron beam source for emitting an electron beam of small energy dispersion, which comprises a needle (11) made of a conductor, a barrier layer (12) having a thickness not larger than the penetration length of electron wave, and a quantum well layer (13), the barrier layer (12) and the quantum well layer (13) being disposed on a surface of the needle, wherein a negative voltage is applied to a counter electrode to thereby emit an electron beam. An electron beam source capable of emitting an electron beam of very small energy dispersion is obtained, so that a high-resolution electron microscope, a high-performance electron spectrometer or a high-performance electron diffractometer can be formed.

FIG. IB

The present invention relates to an electron beam source and an electron beam application apparatus, and particularly relates to an ultra-monochromatic electron beam source suitable for making the resolution of an electron microscope high and suitable for an analyzer for performing material evaluation based on energy analysis, and an electron beam application apparatus and an electronic apparatus using such an ultra-monochromatic electron beam source.

A field emission electron gun is widely used as a conventional electron beam source of small energy dispersion. For example, the operating theory of the field emission electron gun is described in "Electron-Ion Beam Handbook 2nd Edition", pp. 145-151, edited by a 132th committee of the Japan Society for the Promotion of Science (Nikkan Kogyo Shinbun Ltd., 1986). In this electron beam source, a tip of a tungsten (W) cathode is sharpened into a diameter of about 100 nm so that electric field is concentrated into the tip, and field emission electrons emitted from the tip into a vacuum are used.

On the other hand, in order to obtain an electron beam of small energy dispersion in apparatus such as an analyzer using a monochromatic electron beam, a very small part of an electron beam emitted from a conventional electron beam source is extracted by means of a slit or the like after the electron beam is passed through an energy analyzer to disperse energy on the basis of magnetic field or electric field.

A concept that a cathode which comprises a multi-layer structure of Semiconductor/Insulator/ Semiconductor (SIS) being substituted for a conventional cathode which comprises Metal/Insulator/Metal structure (MIM) is disclosed in Takeuchi et al. entitled "Physics and Applications of a Tunneling Effect (Baifukan LTD.,), Chapter 6, pages 88-90, December, (1987). This document however fails to show any concrete structure thereof and a method for applying a voltage thereto. A voltage is applied between a substrate and an upper electrode of the MIM structure to draw out electrons in the substrate to the electrode by the tunneling effect. The potential between the substrate and the electrode becomes larger than a work function thereof, then the emitted electrons are easily emitted into a vacuum therefrom.

JP-A-5-74333 discloses a structure to obtain an electron beam on the basis of a resonant tunnelling effect using a quantum well layer.

In the structure disclosed in JP-A 5-74333, sufficient transparency cannot be obtained, so that there arises a problem that the resulting current intensity is small to make it difficult to use the structure as an electron beam source.

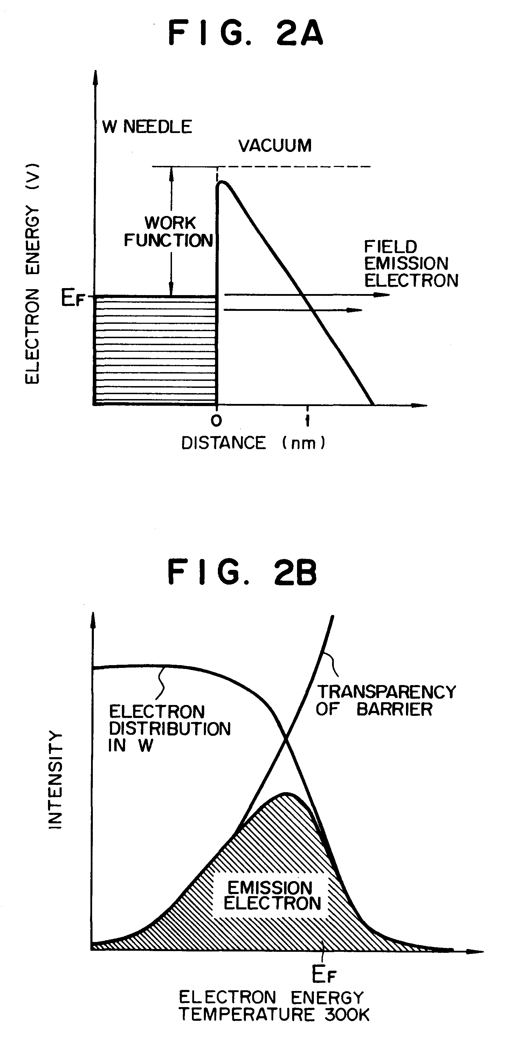

There is a potential energy difference called "work function" between electrons in the inside of W and free electrons in a vacuum, so that electrons in the inside of W never go outside at ordinary temperature. In such a conventional structure, when the vacuum level is bent by application of high electric field intensity to form a thin triangular potential barrier as shown in Fig. 2A, electrons in the inside of W partially pass through the potential barrier by a tunnel effect so as to be emitted into a vacuum. In this case, the energy distribution of the electron beam is expressed as a product of the energy distribution of electrons in the inside of W and the transparency of the potential barrier, as shown in Fig. 2B. As a result, the energy width at half height of emitted electrons is about 0.26 eV at room temperature. When the temperature is made lower, the Fermi distribution of electrons becomes steeper so that the high energy side dispersion is reduced. The energy width at half height is however about 0.2 eV even in the case of absolute zero temperature. This is because the dispersion on the low energy side dispersion with respect to a peak is determined on the basis of the transparency of the potential barrier and because the transparency does not change even in the temperature becomes low. Accordingly, sufficient monochromatic characteristic cannot be obtained in the conventional structure any more, so that there arises a problem that great improvement in resolution of a microscope cannot be attained.

In apparatus such as an analyzer using a monochromatic electron beam, an energy analyzer is used in an electro-optical system. Accordingly, there arise problems that the quantity of the electron beam is reduced, that it is difficult to reduce apparatus size, and so on. Particularly in the case of an electron energy loss spectroscope (EELS) apparatus of high resolution, a high resolution energy analyzer is used in order to obtain an electron beam of an energy width not larger than several tens meV and the quantity of the electron beam is so reduced that a long time is required for the measurement. Further, in this case, there arises a further problem that a large deal of labor is required for assembling and positioning of a high-resolution energy analyzer, for adjustment of an electron beam, and so on. Further, in this case, the size of the analyzer is increased if the focal length of the analyzer is selected to be large. Accordingly, the degree of freedom as to arrangement of the sample, electron beam source and the like is small, so that there arise problems that it is difficult to reduce the size of the apparatus and that it is difficult to multifunctionalize the apparatus in combination with any other apparatus.

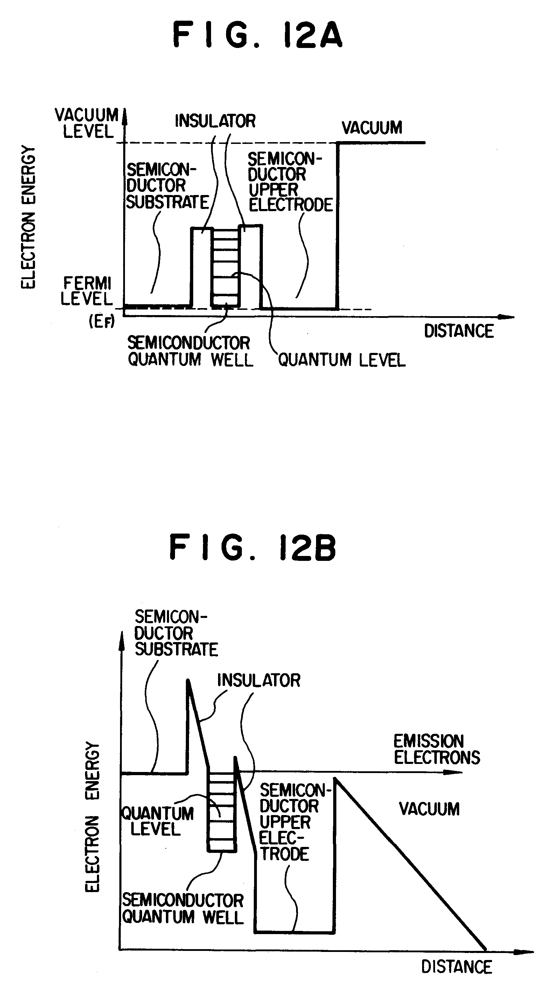

As mentioned above, a concrete structure of the SIS have not been known. The present inventors reached a structure which has a double potential barrier layer as a prior work (refer to Fig. 12A) in which the SIS structure is applied to the conventional MIM structure. In operational condition for the structure shown in Fig. 12A, a potential on the insulator becomes high as shown in Fig. 12B so that a construction in energy of the double potential barrier is asymmetry. Therefore, a resonant condition in which the electron transparency reaches perfectly 1 can not be obtained. Furthermore, the electrons, i.e. hot electrons, near the upper electrodes have a large energy so that they are liable to lose energy therefrom by scattering in a solid and it causes a problem that the emitted electrons have a wide distribution in energy.

A main object of the present invention is to solve the aforementioned problems, to provide an electron beam source for emitting an electron beam of small energy dispersion on the basis of a new theory, and to provide a high-performance electron beam application apparatus and an electronic apparatus using a monochromatic electron beam.

An electron beam source of small energy distribution can be formed when electrons having a specific energy level are extracted selectively from electrons in a solid on the basis of a resonant tunnelling effect using a double potential barrier type quantum well layer. As the width of selection becomes smaller, an electron beam of smaller energy dispersion can be obtained.

A high-performance multifunctional apparatus using a monochromatic electron beam can be formed when an electron beam source of small energy distribution is used. As a result, the energy analyzer having resolution restricted considerably in use can be made unnecessary.

In order to attain the means of selectively extracting electrons having a specific energy level from electrons in a solid, two potential barrier layers with respect to electrons and a quantum well layer surrounded by the double potential barrier are formed in an electron emission path so that a resonant tunnelling effect based on the double potential barrier structure is utilized. That is, when an electron having an energy level coincident with the quantum level in the quantum well enters into the double potential barrier layer, the electron can pass through the double potential barrier layer at a high probability. Not only conditions for this resonance straggle in accordance with the quantum level but also the energy band of high transparency is very narrow. In other words, an electron wave interference filter is formed. When a symmetric structure with respect to the quantum well is formed, the resonance condition that the transparency is perfectly 1 is obtained. Such a symmetric structure can be achieved particularly when two barriers are formed so as to be equal to each other in the barrier height, in the effective mass of electrons and in the barrier thickness.

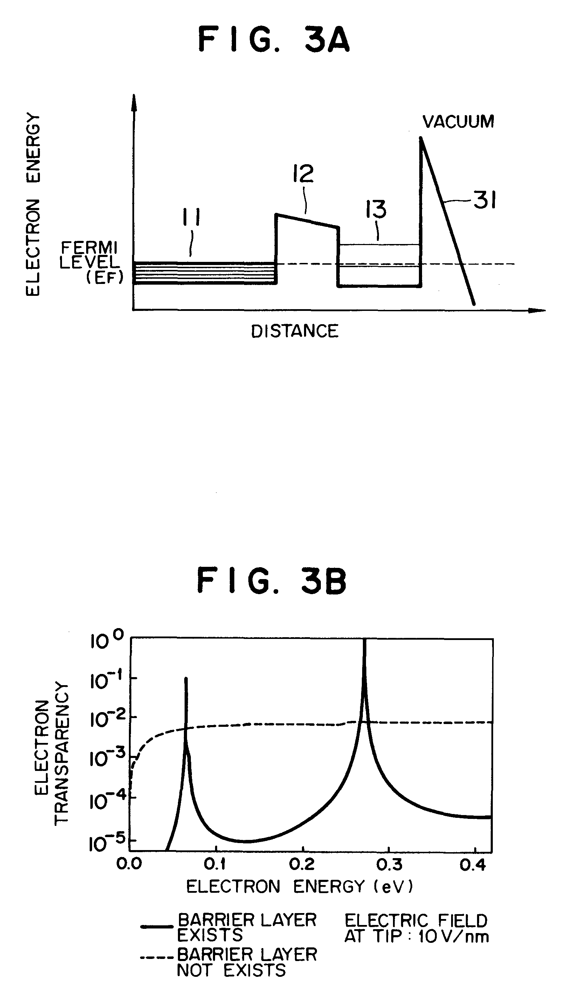

In the present invention, a double potential barrier structure is disposed between a solid and a vacuum in order to apply the resonant tunnelling effect to an electron beam source. As shown in Fig. 3A, a triangular potential barrier 31 constituted by a vacuum level under high electric field intensity is made to be one of the two barriers whereas a thin film 12 formed in the inside of the electron beam source is made to be the other barrier. The quantum well is constituted by a thin film 13. In the case of this electron beam source, materials for the two barriers are different from each other because one barrier is constituted by a vacuum and the other is constituted by a solid. Accordingly, an ideal resonant condition cannot be obtained but a condition near the ideal resonant condition can be selected.

By using WKB approximation, the electron transparency D of one potential barrier is expressed as follows:

$$D = \exp\{2\int k(x)dx\} \quad \text{(Expression 1)}$$

in which $x$ is a variable representing a position, the integral is definite integral over the whole thickness of the barrier layer, and $k(x)$ is expressed by the following expression:

$$k(x) = [\sqrt{\{2m(V(x) - E)\}}]2\pi/h \quad \text{(Expression 2)}$$

in which $m$ represents the effective mass of electrons, $V(x)$ represents the height of the barrier, E represents the energy of electrons, and $h$ represents Planck's constant.

The reciprocal of $k(x)$ corresponds to the length of penetration of electron wave into the barrier. The value of D increases as the thickness decreases and as the penetration length increases. In order to obtain a condition near the ideal resonant condition, it is preferable that the value of D in one barrier and the value of D in the other barrier are substantially equal to each other and larger than the order of 1/1,000,000. With respect to the potential barrier 31 formed in a vacuum, this condition is achieved by controlling the potential barrier on the basis of external electric field. That is, electric field intensity in a range of from 3 V/nm to 10 V/nm is required. This condition is achieved by forming a structure having a convex tip like a field emission electric beam source.

With respect to the barrier layer 12 disposed in the electric beam source, this condition can be achieved by setting the film thickness to be substantially equal to the penetration length determined on the basis of the effective mass $m$ of electrons, the barrier height V and the electron energy E. That is, it is possible to provided a monochromatic electron beam source of very small energy dispersion which is an object of the present invention.

As described above, in the present invention, a resonant tunnelling effect is generated between a solid and a vacuum, so that a condition for obtaining a sufficient quantity of electron beam is obtained differently from the case shown in Figs. 12A and 12B. There arises an advantage that an electron beam excellent in monochromatic characteristic and sufficiently large in current intensity is obtained.

By using an electron beam source of very small energy distribution, the high-resolution energy analyzer which has been used in a conventional monochromatic electron beam apparatus becomes unnecessary. Accordingly, in a simpler structure, the electron beam can reach the surface of the sample without the energy loss of the electron beam. Accordingly, an analyzer capable of performing measurement in a short time can be provided.

The present invention will be described below in detail with reference to the following drawings.

Figs. 1A and 1B are views showing the structure of Embodiment 1 of the present invention and the energy structure thereof, respectively;

Figs. 2A and 2B are views showing the energy structure of a conventional example and the emission electron energy distribution thereof, respectively;

Figs. 3A and 3B are views for explaining the operating theory of Embodiment 1 of the present invention and the emission energy distribution thereof, respectively;

Fig. 4 is a view showing the structure of Embodiment 2 of the present invention;

Figs. 5A to 5E are views showing the process of production of Embodiment 3 of the present invention;

Figs. 6A to 6D are views showing the process of production of Embodiment 4 of the present invention;

Figs. 7A and 7B are views showing the process of production of Embodiment 5 of the present invention;

Fig. 8 is a view showing the structure of Embodiment 6 of the present invention;

Fig. 9 is a view showing the structure of Embodiment 6 of the present invention;

Fig. 10 is a view showing the structure of Embodiment 6 of the present invention;

Figs. 11A and 11B are views showing the structure of Embodiment 7 of the present invention and the energy structure thereof, respectively; and

Figs. 12A and 12B are views showing the energy structure at the time of application of no voltage and the energy structure at the time of application of a voltage respectively, in a structure which can be easily inferred as an example of a double potential barrier structure formed by using an SIS multilayer film in a conventional MIM structure.

Embodiment 1

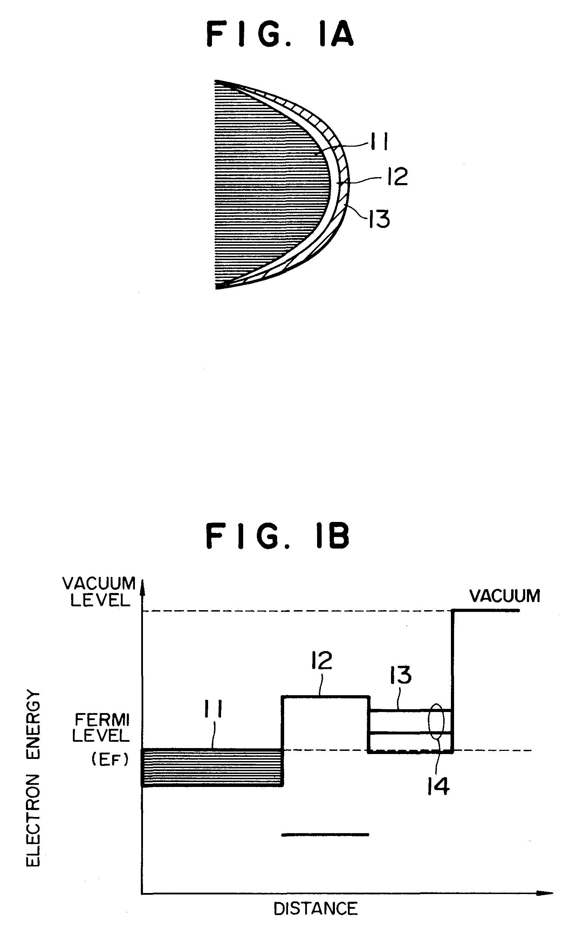

Referring to Fig. 1A, there is shown an embodiment of the present invention. A needle 11 of an n+ type GaAs single crystal extending in the (111) orientation and having a tip with a radius of curvature of 0.1 μm is used as a first material. A 1.4 nm-thick single crystal AlAs film 12 as a second material and a 7 nm-thick single crystal GaAs film 13 as a third material are grown successively one on one in this order in the tip region of the needle 11 by molecular beam epitaxy (MBE). As a result, such an energy structure shown in Fig. 1B is formed. The resulting structure is introduced into a vacuum equipment and heated at 540 °C for 5 minutes to clean the surface thereof. Then a negative voltage is applied to an anode disposed as a counter electrode to an extent that the intensity of electric field in the vicinity of the tip of the needle 11 becomes a value in a range of from about 3 V/nm to about 10 V/nm, such a structure as shown in Fig. 3A is formed so that the number of tunnel emission electrons increases. Because electron transparency has such energy dependance as shown in Fig. 3B, an electron beam which is very small in energy dispersion is obtained. At room temperature, the thermal energy dispersion is about 26 meV. When a cryostatt is further mounted to the electron beam source, it is possible to obtain an electron beam having energy dispersion of 7 meV in the case of liquid nitrogen temperature (77 K) or an electron beam having energy dispersion of 1 meV in the case of liquid helium temperature (4 K).

In this embodiment, the GaAs quantum well layer 13 which is the outermost material, that is, the third material, is not subjected to impurity doping. In the case where the presence of surface level makes the operating condition unstable, Si which is $\underline{n}$ type impurity may be doped into the GaAs quantum well layer 13 by an amount of about $10^{12}$ per $cm^2$ to thereby achieve an advantage that the surface potential is fixed to achieve a stable operation.

This embodiment has shown the case where n+ type GaAs, 1.4 nm-thick AlAs and 7 nm-thick GaAs are respectively used as the first material for the base material 11, the second material for the barrier layer 12 and the third material for the quantum well layer 13 in the electron beam source. However, even in a case where a combination of materials other than those mentioned above, for example, a combination of n+ type GaAs, AlGaAs and GaAs, a combination of other Group III-Group V compound semiconductors, that is, a combination of lattice mismatch systems such as In-GaAsP mixed crystal, a combination of Group II-Group VI compound semiconductors such as a combination of n+ type ZnSe, ZnS and ZnSe, or a combination of Group IV semiconductors such as a combination of n+ type Ge, Si-Ge and Ge is used, the same effect as described above can be achieved as long as the thickness of the barrier layer and the thickness of the quantum well layer are adjusted in accordance with the effective mass and electron potential of the respective materials because in those combinations, the materials have similar physical properties. In the case of indirect transition type semiconductors such as Ge, the orientation small in effective mass may be selected as the direction of the running of electrons to heighten the effect. On the other hand, if the direction of the running of electrons is selected as the crystal orientation small in work function of surface material, electron beams small in divergence angle and excellent in converging characteristic can be obtained so as to be suitable for high resolution in the case where this structure is applied to an electron microscope or the like.

Although this embodiment has shown the case where semiconductors are used as a combination of materials, an electron beam source large in current quantity can be obtained in the case where a metal, a semimetal, or the like, larger in electron density than the semiconductor is used as the first material for the base material of the electron beam source. If, for example, single crystal NiAl is used as the first material, n+ type GaAs, AlGaAs and GaAs single crystals as the second and third materials can be grown on the first material. If, for example, single crystal $CoSi_2$ is used as the first material, Si and Ge single crystals can be grown. Also in the case where an insulator having a thickness of not larger than about 1 nm is used as the second material for the barrier layer, the same effect as in this embodiment can be achieved. If, for example, single crystal $CaF_2$ is combines with Si and GaAs and single crystal $Al_2O_3$ is combined with Si, single crystal growth can be achieved. Because the thermal strength of these combinations is higher than that of semiconductors, these combinations have an advantage that they can operate even in the condition of high current intensity. Accordingly, if such a metal, an insulator and a semiconductor are used in combination, the effect is heightened more greatly.

Although this embodiment has shown the case where MBE is used as a crystal growth method, the same effect as in this embodiment can be achieved even in the case where any method such as metallorganic chemical vapor deposition (MOCVD), chemical vapor deposition (CVD), etc. is used as long as a single crystal thin film can be grown by the method.

Although this embodiment has shown the case where single crystals are used as materials, the same effect as in this embodiment can be achieved even in the case where amorphous materials having a thickness of not larger than about 1 nm are used. In the latter case, there arises an advantage that these amorphous materials can be easily formed on a known needle-shaped W electron beam source by a plasma CVD method, a low-temperature evaporation method, or the like. Examples of the amorphous materials include combinations of Group IV chalcogens such as a-Si, a-Si-C, a-Si-N, a-Si-Ge, etc., and combinations of S-Se-Te type chalcogens.

Although this embodiment has shown the case where a pair of barrier layers and a quantum well layer making are used, the same effect as in this embodiment can be achieved even in the case where a plurality of pairs of barrier layers and quantum well layers are provided. In the latter case, there arises an advantage that electron beams can be obtained by a lower extraction voltage when the outer materials for the barrier layer and the quantum well layer are selected to be higher in electron potential, that is, lower in work function than the inner material. Further, there arises an advantage that electron beams smaller in energy dispersion and larger in current can be obtained when the peak energy of state density of very small energy dispersion generated in the inner quantum well layer is made coincident with an electron wave interference filter constituted by the outer barrier layer and quantum well layer by voltage application or the like.

Although this embodiment has shown the case where electric field is concentrated into a needle-shaped tip to thereby form a thin potential barrier 31 under vacuum conditions, the same effect as in this embodiment can be achieved even in the case where the tip is shaped like a wedge. In the latter case, linear electron beams can be obtained. Although this embodiment has shown the case where the radius of curvature of the tip is 0.1 µm, the same effect as in this embodiment can be achieved even in the case where the tip has a large radius of curvature of about 3 µm as long as the counter electrode can be brought close to about 10 µm.

Embodiment 2

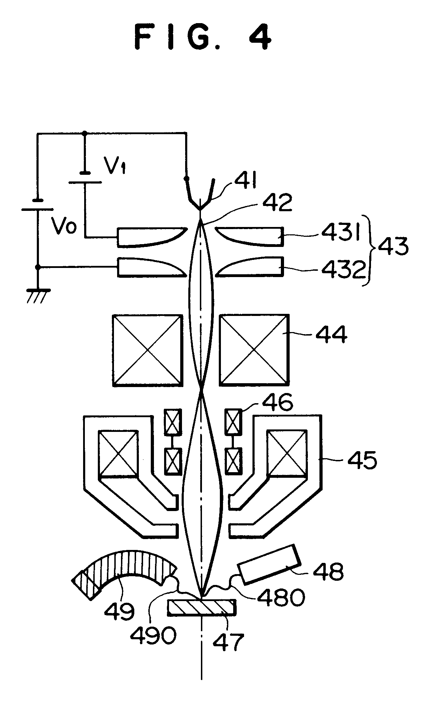

Referring to Fig. 4, there is shown an embodiment in which the electron beam source according to the present invention is applied to an analyzer.

An electron beam 42 is emitted from an electron beam source 41 on the basis of a voltage $V_1$ (about 2.5 kV) applied to a first anode 431 of an acceleration lens 43. Then, a voltage $V_0$ (=100 V) is applied to a second anode 432 of the acceleration lens 43 to obtain an electron beam with a desired acceleration voltage. The electron beam 42 having passed through the acceleration lens 43 is narrowed by a condenser lens 44 and an objective lens 45 and then radiated onto a sample 47. When secondary electrons 480 generated in this occasion are detected by a secondary electron detector 48 so that the detected signal intensity obtained by the secondary electron detector 48 is indicated on a CRT in synchronism with a deflection signal of a deflector 46 which scans the electron beam 42 secondarily on a surface of the sample 47, an SEM image is obtained. In this embodiment, an electrostatic energy analyzer 49 is disposed so that reflected electrons 490 obtained by reflection on the sample 47 can be subjected to energy analysis. This is for the purpose of finding the surface state of the sample 47 by measuring the energy loss of the electron beam 42 on the sample 47. For example, the electron state of the surface chemical species can be found in an energy loss range of from the order of eV to the order of hundreds of meV. Further, the vibrational state of the surface chemical species can be found in an energy loss range of the order of tens of meV. Accordingly, there arises, for example, an advantage that elements and adsorbed molecules in the first layer of the sample surface as to kind and adsorption state can be analyzed locally. Further, there arises an advantage that measurement can be made in a short time because the electron beam device is simple in structure so that the electron beam reaches the sample surface without reduction of the quantity of the electron beam compared with a monochromatic electron beam device using a conventional high-resolution energy analyzer.

In this embodiment, the electron beam 42 has small energy dispersion of about 25 meV. Accordingly, even in the case where the acceleration voltage $V_0$ is selected to be a small value of 100 V, chromatic aberration can be reduced to a small value so that the electron beam 42 on the sample 47 was narrowed to about 20 nm. That is, judging from the fact that the acceleration voltage in the conventional field emission electron beam source is about 0.1 μm, it is apparent that the electron beam source according to the present invention is suitable for high space resolution. On the other hand, with respect to energy analysis, small energy dispersion of about 25 meV was provided, so that the limit range of precision measurement of energy loss was about 30 meV. Judging from the fact that the limit range of measurement of energy loss is about 0.5 eV when this analysis is performed by the conventional field emission electron beam source, it is apparent that the electron beam source according to the present invention is very effective for high energy resolution in such an analyzer.

If a rotation mechanism for rotating the sample 47 and the energy analyzer 49 is provided so that measurement is performed while the incident angle of electrons is changed, orientation of a specific chemical bond can be found. If an electron lens is provided at an inlet of the energy analyzer 49 so that electrons from a wider range can be measured, a two-dimensional image of a surface chemical state can be obtained.

An example of an apparatus using the electron beam source according to the present invention has been described above. It is a matter of course that the present invention as to the respective numbers of lenses and deflectors and the arrangement thereof is not limited to this embodiment and that the analyzer used in this embodiment is not limited to the electrostatic type analyzer.

Although this embodiment has shown the case where a high-resolution scan electron microscope and an electron spectrometer are used in combination from the point of view of the merit of an electron beam source excellent in monochromatic characteristic, it is a matter of course that they are useful when they are used singly respectively. In the case where this embodiment is applied to an electron spectrometer, an energy analyzer may be disposed between the electron beam source and the sample to form an analyzer of higher energy resolution. Although this embodiment has shown the case where an electron beam source excellent in monochromatic characteristic is used for the double purpose of high space resolution and high energy resolution, there arises an advantage that the distance between atom chains can be measured accurately if, for example, the electron beam source is applied to a reflection electron beam diffractometer from the point of view of the high coherency thereof.

Although this embodiment has shown the case where a scan electron microscope is used as an example showing the fact that chromatic aberration can be reduced to thereby narrow the electron beam on the sample regardless of the small acceleration voltage when the energy dispersion of the electron beam is small, this electron gun is also useful in the case where this electron gun is applied to an electron beam lithography machine used in the semiconductor production process. In electron beam lithography, an electron beam is radiated onto an organic resist film having been applied onto a surface of a substrate so that a fine pattern is formed on the basis of the local chemical reaction of the resist film.

In order to reduce chromatic aberration to thereby narrow the electron beam, the conventional electron beam requires an acceleration voltage of not smaller than a value in a range of from the order of keV to the order of tens of keV. Because the high-speed electrons generate a large amount of secondary electrons in the substrate to cause the chemical reaction of the resist film, the resulting resist pattern becomes thicker than the electron beam size so that the formation of such a fine pattern is limited. Further, because the high-speed electrons are small in scattering cross-section with respect to the resist material, high current intensity of about 1 mA/sr as angular current intensity of the electron beam source is required for high-speed lithography. There arises a problem that the high current intensity causes unstabilization or degradation of the electron beam source. When the electron beam source according to the present invention is used, the acceleration voltage can be reduced so that these problems can be solved easily. Particularly when the acceleration voltage is used in a range of from the order of eV to the order of tens of eV, the acceleration voltage acts directly on the chemical bonds of the resist material so that the scattering cross-section becomes very large. There arises an advantage that high-speed lithography can be performed even in the case where the angular current intensity is very low. Further, because the generation of secondary electrons is almost suppressed, there arises an advantage that a more fine pattern can be formed.

Embodiment 3

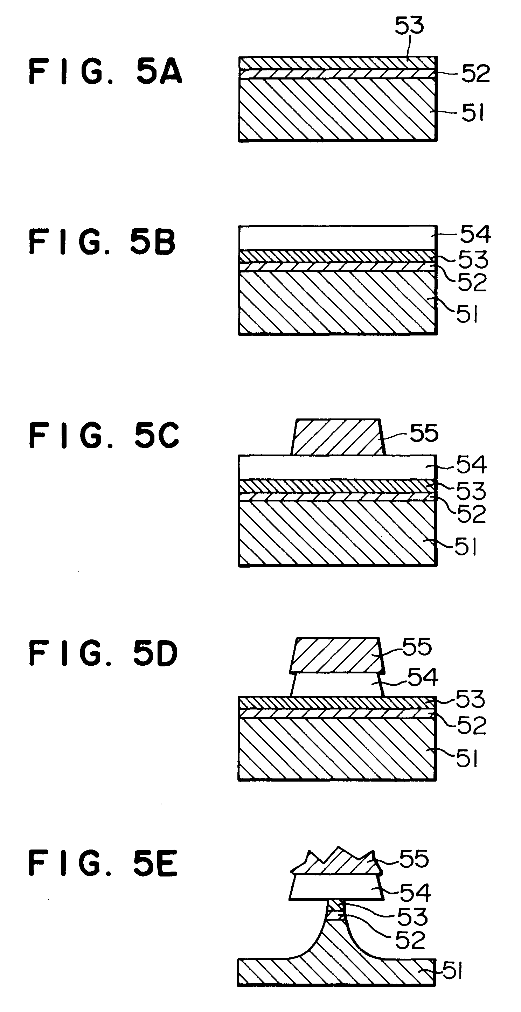

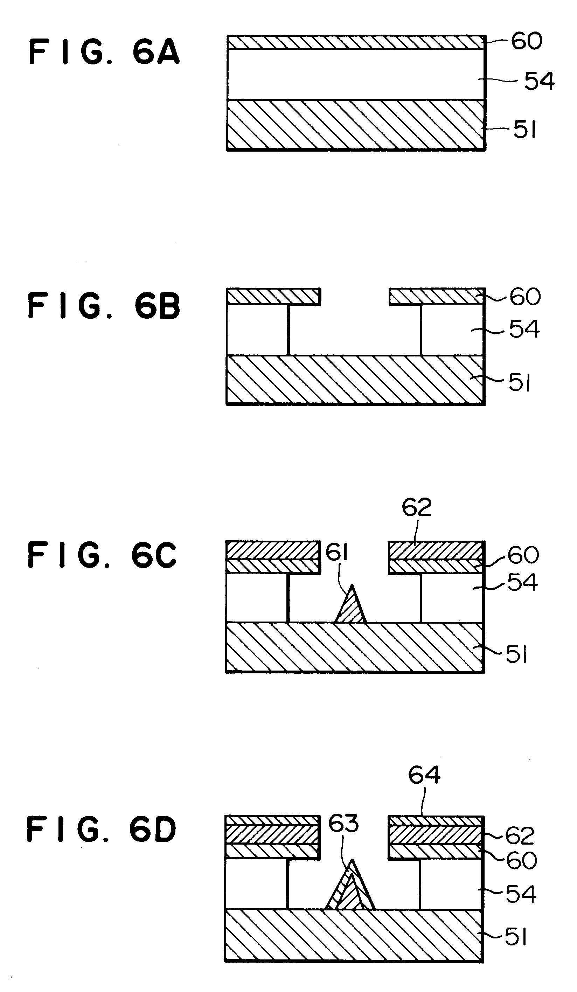

Referring to Figs. 5A through 5E, there is shown an embodiment of the present invention. On an n+ type GaAs (111) B-side substrate 51 as a first material, single crystal growth of a 1.4 nm-thick AlAs layer 52 as a second material and a 7 nm-thick GaAs layer 53 as a third material is performed by MBE (Fig. 5A). Then, a 200 nm-thick $SiO_2$ layer 54 is deposited thereon by CVD (Fig. 5B). A photoresist film 55 having a diameter of about 100 $\mu$m is formed on a desired region of a surface thereof (Fig. 5C). The $SiO_2$ layer 54 having been masked with the photoresist film 55 is etched with an HF-$NH_4OF$ mixture solution (Fig. 5D). The GaAs layer 53, the AlAs layer 52 and the n+ type GaAs (100) substrate 51 having been masked with the thus formed $SiO_2$ layer 54 are etched with an $H_2SO_4$-$H_2O_2$ mixture solution kept at 60 °C. Because GaAs is isotropically etched with this solution, downward etching of the substrate and side etching of GaAs under the $SiO_2$ layer are performed simultaneously. Accordingly, when etching is stopped at a suitable point of time, a needle-shaped structure having a tip coated with GaAs/AlAs thin film is produced (Fig. 5E). Thereafter, the residual $SiO_2$ layer 54 in the upper portion is removed by ultrasonic cleaning or the like thus to obtain an electron beam source having the same structure as in Embodiment 1. This embodiment has an advantage that a large number of electron beam sources can be produced at once reproducibly.

In the case where the electron beam sources are to be used singly, the back surface of the substrate 51 is cut so as to be made thin; a layer for ohmic contact such an Au-Ge-Ni film, etc. and an adhesive layer such as solder, Au, etc. are formed on the back surface of the substrate 51; and then electron beam source parts are cut off one from one, and stuck by heating onto metal mounts respectively.

Although this embodiment has shown the case where GaAs and AlAs are used as materials, the same effect as in this embodiment can be achieved even in the case where other materials as shown in Embodiment 1 are used as long as the aforementioned procedure is carried out.

Embodiment 4

Referring to Figs. 6A to 6D, there is shown an embodiment of the present invention. On an n+ type GaAs (111) substrate 51, a 2 $\mu$m-thick $SiO_2$ layer 54 and a 500 nm-thick W layer 60 are deposited by CVD (Fig. 6A). Then, the W layer 60 masked with a photoresist film provided with a hole having a diameter of 2 $\mu$m is etched with an $NH_4OH$-$H_2O_2$ aqueous solution to form a hole in the W layer 60 and then the $SiO_2$ layer 54 is etched with an HF-$NH_4OF$ mixture aqueous solution. In this occasion, the time required for etching the $SiO_2$ layer 54 is selected to be longer than the time required for etching the W layer 60, so that a larger hole than the hole of the W layer 60 is formed in the $SiO_2$ layer 54 (Fig. 6B). After removal of the photoresist film and cleaning, the GaAs substrate is introduced in a super-high vacuum. Under super-high vacuum conditions, the surface of the GaAs substrate is heated at 540 °C for about 5 minutes so as to be cleaned. Then, the GaAs substrate is coated with 1.5 $\mu$m-thick NiAl by an evaporation method at the rate of about 0.1 nm/sec while the substrate temperature is kept about 540 °C. As a result, a polycrystalline NiAl film 62 is formed on the W layer and at the same time conical single crystal NiAl 61 as a first material is formed on the GaAs substrate 51 (Fig. 6C). Then, a multilayer film consisting of 1.4 nm-thick AlAs and 7 nm-thick GaAs as second and third materials is evaporated so that the surface of the single crystal NiAl 61 is coated with the single crystal AlAs-GaAs multilayer film 63 (Fig. 6D). The other region is provided as a polycrystal 64. As a result, an electron beam source having the same structure as in Embodiment 1 is produced. This embodiment has an advantage that a large number of electron beam sources can be produced at once reproducibly. When the W layer 60 is used as an electrode for extracting electrons, there arises an advantage that not only a monochromatic electron beam can be obtained even in the case of a small extraction voltage but a small-sized monochromatic electron beam source device can be obtained because the distance between the cathode and the anode is in a small value of about 1 $\mu$m.

Although this embodiment has shown the case where NiAl, GaAs and AlAs are used as materials, the same effect as in this embodiment can be achieved even in the case where other materials as shown in Embodiment 1 are used as long as the aforementioned procedure is carried out.

The same effect as in this embodiment can be achieved even in the case where another process than the forming process used in this embodiment is used as long as the same structure as described above can be formed.

When a large number of electron beam sources formed on the substrate in this embodiment are used, a multibeam consisting of monochromatic electron beams is obtained so as to be effective for high throughput of the electron beam lithography machine, high speed of the CRT display, high precision thereof, reduction in size thereof, and so on.

Embodiment 5

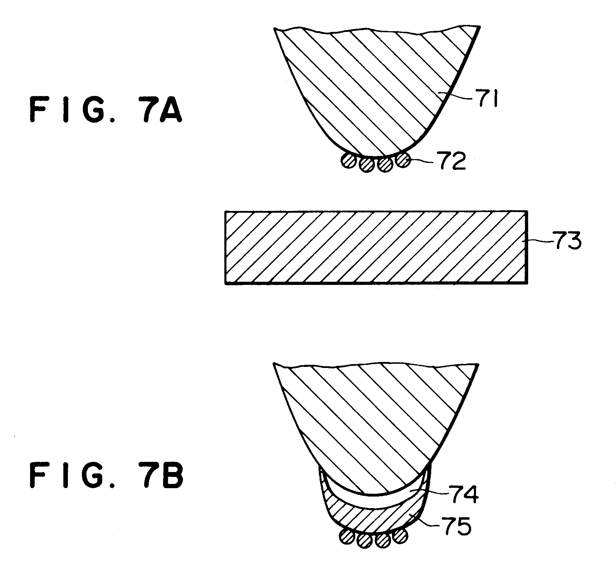

Referring to Figs. 7A and 7B, there is shown an embodiment of the present invention.

A W needle 71 is obtained by electrolysis etching of W single crystal with a KOH aqueous solution. The W needle 71 used as a probe of a scan tunnel microscope is approached to the distance of about 1 nm from an Au substrate 73 and then pulses of from -7 V to -15 V are applied to the needle. As a result, an adsorbed layer 72 of Au with the thickness of about one atom is formed on a very small region of the tip of the W needle as shown in Fig. 7A. Then, in a reactor chamber, the W needle 71 as a first material is heated in a temperature range of from 400 °C to 500 °C and trimethylaluminum (TMA), trimethylgallium (TMG) and arsine (AsH$_3$) are introduced at the flow rate of 10$^{-6}$ mol/s respectively, so that a 2 nm-thick Al$_{0.4}$Ga$_{0.6}$As film 74 as a second material is grown only on a region where the adsorbed layer 72 of Au is present. Then, TMG and AsH$_3$ are introduced therein, so that an 8 nm-thick GaAs film 75 is grown as a third material. Thus, a structure shown in Fig. 7B is obtained. When this needle is used as a cathode, an electron beam can be obtained only from the very small region of the tip of the needle. As a result, not only monochromatic characteristic but high brightness of the beam source could be achieved. Accordingly, higher resolution of the electron microscope is achieved by using this embodiment.

Although this embodiment has shown the case where semiconductors are grown on the W needle formed by etching, conditions for the tunnel effect are completed more effectively in the case where semiconductors are grown after a crystallographically stable surface is once formed on the tip by the process of heating the tip to a temperature of not lower than about 1000 °C in a high vacuum.

Although this embodiment has shown the case where an AlGaAs-GaAs system based on a gas source as selectively grown in the presence of an absorbed layer of Au is used as an example of a combination of a barrier layer and a quantum well layer, the same effect as in this embodiment can be achieved even in the case where various materials shown in Embodiment 1 are used as long as the same structure as described above can be formed.

Although this embodiment has shown the case where a surfactant (surface active agent) effect of Au attached to the tip of the needle under a scan tunnel microscope is used for selectively growing the barrier layer and the quantum well layer on the tip, it is to be understood that another material having the same effect as described above may be used and that the same effect as in this embodiment can be achieved in the case where the barrier layer and the quantum well layer are selectively grown on the tip of the W needle by the method of applying a voltage to the W needle to dissolve material gas through high electric field intensity on the tip without use of any scan tunnel microscope.

Embodiment 6

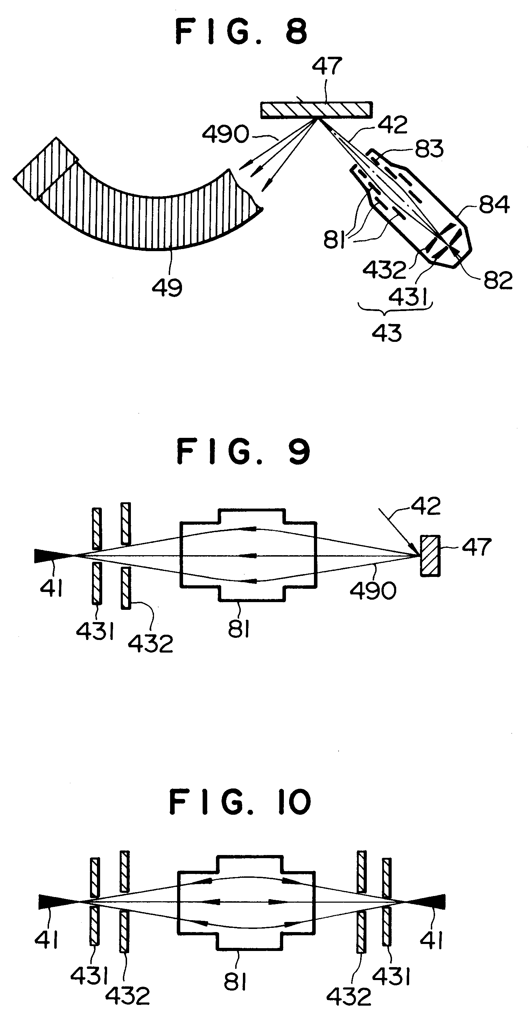

Referring to Fig. 8, there is shown an embodiment of the present invention applied to a surface analyzer.

An electron beam 42 from an electron gun 84 is radiated onto a surface of a sample 47 put in a super-high vacuum. Reflected electrons 490 obtained from the sample 47 are analyzed by an electrostatic energy analyzer 49 so that the energy loss of the electron beam 42 is measured. In the electron gun 84, the electron beam 42 generated by an electron beam source 82 excellent in monochromatic characteristic and an acceleration lens 43 is converged onto the sample surface by an electrostatic electron lens 81. The position of convergence is adjusted by an electrostatic deflector 83. In this manner, the surface state of the sample can be found. Embodiment 2 has shown the case where a function of surface analysis as described above can be added to a scan electron microscope by using a monochromatic electron beam source. In this embodiment, a monochromatic electron beam is obtained without use of any high-resolution energy analyzer, so that surface analysis can be performed through a very small-sized electron gun. Accordingly, this embodiment has an advantage that the surface analyzer can be provided as a surface monitor in an apparatus in which the surface state of the sample in a super-high vacuum is put in question, that is, for example, in a molecular beam epitaxy (MBE) apparatus. As the electron beam source 82 excellent in monochromatic characteristic, an electron beam source having energy dispersion corresponding to necessary information is used. When, for example, elements in the surface are required to be known, a needle-shaped W field emission electron beam source may be used because the energy loss is in a range of from the order of eV to the order of hundreds of eV. When, for example, adsorbed molecules as to kind, adsorbed state, etc. are required to be known more in detail, an electron beam source using a resonant tunnelling effect as shown in Embodiment 1 may be used because the energy loss is in a range of the order of tens of meV.

Although this embodiment has shown the case where an electrostatic energy analyzer 49 is used as a means for measuring the energy loss of the electron beam 42, it is to be understood that the present invention can be applied to the case where another means is used, and that reduction in size can be achieved more greatly when a schottky diode energy analyzer is used.

In the case of high precision measurement, reduction in size can be achieved when an energy analyzer as shown in Fig. 9 is used while an electron beam source using a resonant tunnelling effect is applied. The energy analyzer comprises an electron beam source 41, a first anode 431, a second anode 432, and an electrostatic electron lens 81. Reflected electrons 490 obtained from a surface of a sample 47 are converged to the electron beam source 41 by the electrostatic electron lens 81. An electron wave interference filter having a resonant tunnelling effect as shown in Figs. 3A and 3B is formed on the basis of a constant voltage (about 2.5 kV) applied between the electron beam source 41 and the first anode 431. The electron wave interference filter functions independent of the direction of the movement of electrons. In this occasion, electrons are allowed to enter from a vacuum into a solid only in the case where the energy level of electrons is coincident with the quantum level in the quantum well (13 in Fig. 3A). Accordingly, the current change is measured while the potential of the electron beam source 41 is swept in the vicinity of the energy of the reflected electrons 490, so that the energy distribution of the reflected electrons 490 can be measured with high accuracy. When the width of the quantum well in the electron beam source 41 is selected to be smaller than that in Embodiment 1, that is, when, for example, the thickness of the GaAs layer of 7 nm in Embodiment 1 is changed to 4 nm, the energy of the quantum level in the quantum well increases so that incident electrons can be measured effectively while electron emission of the electron beam source 41 is suppressed.

From the point of view of the fact that the energy analyzer using the electron wave interference filter has the same structure as the monochromatic electron gun shown in Fig. 8, an electron beam resonator as shown in Fig. 10 can be formed by arranging the energy analyzer and the monochromatic electron gun so as to be directly opposite to each other. In this case, when the potentials of the two electron beam sources are adjusted to make the emission electron energies coincide with each other, the current between the two electron beam sources becomes zero in the case of no loss, so that standing wave of electrons can be formed easily in a vacuum.

Embodiment 7

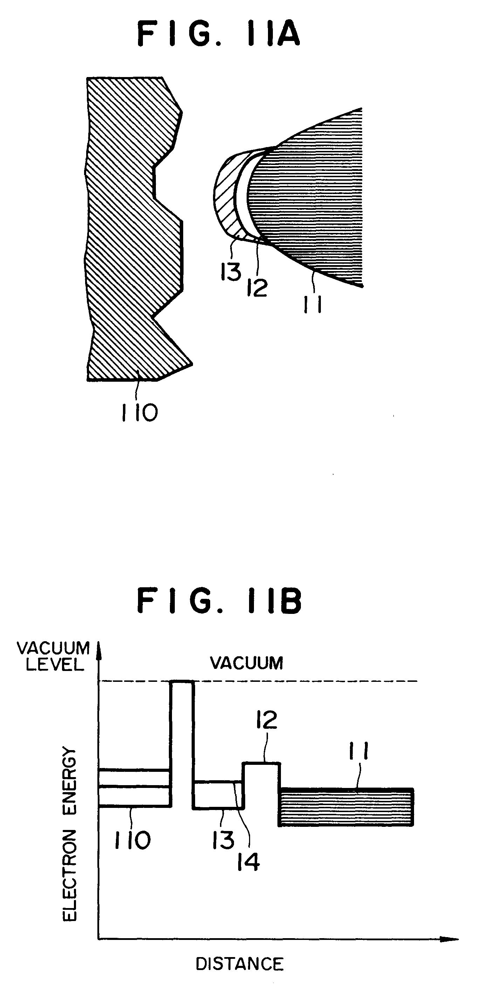

Referring to Figs. 11A and 11B, there is shown an embodiment in which the electron beam source according to the present invention is applied to an analyzer.

Like Embodiment 1, an n+ type GaAs single crystal needle 11 extending in the (111) direction is used as a first material. A 1.4 nm-thick single crystal AlAs film 12 as a second material and a 2 nm-thick single crystal GaAs film 13 as a third material are grown on a tip region of the needle by a molecular beam epitaxy (MBE) method thus to form a probe of a scan tunnel microscope. If the probe is approached to a distance of about 1 nm, energy levels as shown in Fig. 11B are formed. When a voltage is swept in this condition, the current increases with the increase of electron transparency on the basis of the resonant tunnelling effect at a point where the energy level of the surface of the sample 110 coincides with the quantum level 14 of the GaAs film 13. As a result, the electron state of the surface can be found. Information as to kind of elements in the surface, kind and adsorbed state of adsorbed molecules, etc. can be known in the same manner as in the case of the reflected electron energy loss spectrometry as shown in Embodiments 2 and 6. When the probe is set in negative potential with respect to the substrate, the levels of the positions of absence of electrons are measured among the energy levels of the surface of the sample 110. When the probe is set in positive potential, the levels of the positions of presence of electrons are measured. Accordingly, surface potential, surface band structure, and so on, can be found. Further, the scan tunnel microscope is very high in transverse space resolution, so that there arises an advantage that respective atoms or molecules can be observed directly when a plurality of scan tunnel microscopes are used in combination for measurement.

Although this embodiment has shown the case where a scan tunnel microscope is used, the same effect as in this embodiment can be achieved even in the case where the scan tunnel microscope is replaced by another means such as an atom force microscope as long as the needle can be approached to the vicinity of the sample surface by the means.

As described above on the basis of embodiments, an electron beam source for emitting an electron beam of very small energy dispersion is obtained in accordance with the present invention. As a result, a high-resolution electron microscope, a high-performance electron spectrometer, a high-performance electron beam diffractometer or a high-performance electron apparatus can be formed.

## Claims

1. An electron beam source comprising a structure which has a double potential barrier type quantum well layer and in which the electron transparency of the double potential barrier layer (12,31) including a quantum well layer (13) is selected to be substantially 1.

2. An electron beam source according to claim 1, wherein said double potential barrier layer has a structure in which penetration lengths of electrons in respective potential barrier layers (12,31) are substantially coincident with each other.

3. An electron beam source according to claim 1, wherein said double potential barrier layer has a structure in which said double potential barriers (12,31) control the thicknesses and heights of potential barriers and the effective mass of electrons so that penetration lengths of structures formed symmetrically with electrons with respective to the respective potential barrier layers are substantially coincident with each other.

4. An electron beam source comprising: a conductor (11) made of a first material having a projection of height H and a flat or convex region of width d formed at a tip of said projection and having a shape in which the height H and the width d satisfy the relation H>10d; and at least one pair of a quantum well layer (13) and an electron barrier layer (12) disposed on a surface of said first material (11), said quantum well layer (13) being made of a third material, said electron potential barrier layer (12) being made of a second material and disposed between said first material (11) and said quantum well layer (13), said electron beam source having a structure in which the thickness of said potential barrier layer (12) is not larger than the penetration length of electron wave; wherein a voltage, which is relatively negative with respect to a potential at an anode opposing to the electron beam source, is applied to said first material (11) so that an electron beam is emitted therefrom.

5. An electron beam source according to claim 4, wherein the width d is selected to be not larger than 3 μm.

6. An electron beam source according to claim 4, wherein: said cathode is formed as a needle-shaped structure; the tip of said cathode for emitting electrons has a semispherical shape with a radius of not larger than 1.5 μm or a convex shape which does not project out of said semispherical shape; the structure of said cathode is formed by successively laminating at least one pair of said second material (12) and said third material (13) on the surface of said first material (11) which is said conductor; said first material (11) has state density in an Fermi level region; said second material (12) has not its electron level in a range of ±30 meV with respect to the Fermi level of said first material (11) when said second material (12) is in contact with said first material (11); said second material (12) has a thickness not larger than the penetration length of electron wave; said third material (13) has its conduction electron level in a position of lower energy by a value of not smaller than 30 meV than the minimum level of said second material (12) in which there is no electron when said third material (13) is in contact with said second material (12); and said third material (13) has a structure in which the thickness of said third material (13) is substantially equal to the De-Brogie wave length of conduction electrons.

7. An electron beam source according to claim 4, wherein at least two multilayer covering structures each constituted by said second and third materials (12,13) are successively laminated on a surface of said first material (11) which is the conductor, and wherein materials constituting the multilayer covering structure other than a first one of said multilayer covering structures is different in at least one kind from those constituting said first multilayer covering structure.

8. An electron beam source according to claim 4, wherein each of said first, second and third materials constituting said electron beam source is a semiconductor single crystal, wherein the crystal of said second material (12,52) is epitaxially grown on the crystal of said first material (11,51) which is a base material, and wherein the crystal of said third material (13,53) is epitaxially grown on the crystal of said second material.

9. An electron beam source according to claim 4, wherein said first material is a single crystal metal or semimetal, wherein the crystal of said second material is epitaxially grown on the crystal of said first material which is a base material, and wherein the crystal of said third material is epitaxially grown on the crystal of said second material.

10. An electron beam source according to claim 4, wherein at least one material among said first, second and third materials constituting said electron beam source is amorphous or micro-crystalline.

11. An electron beam source apparatus comprising at least one kind of electron beam sources as defined in claim 4, wherein said electron beam sources are formed on one and the same substrate, and wherein anodes corresponding to said electron beam sources are formed on the same substrate (Fig. 6A-6D).

12. An electron beam source according to claim 4, wherein the whole structure of said electron beam source is shaped like a needle by etching using welding, gas, plasma, etc. after laminating said second and third materials on said first material which is a substrate.

13. An electron beam source according to claim 4, wherein thin films of said second and third materials are formed in layers on said first material shaped like a needle.

14. An electron beam source according to claim 4, wherein a combination of Group III-Group V compound semiconductors such as GaAs-AlAs are used as said second and third materials.

15. An electron beam source according to claim 14, wherein a direct transition type material such as a mixed crystal of GaAs and $Al_xGa_{(1-x)}As$ in which x represents a value not larger than 0.4 is used as said semiconductors.

16. An electron beam application apparatus wherein at least one electron beam source selected from the electron beam sources as defined in claim 1 is used as an electron beam source.

17. An electron beam application apparatus according to claim 16, comprising said electron beam source (41), an electro-optical system including an electron lens (43,44,45) and a deflector (46), and an electron energy analyzer (49), wherein an electron beam (42) emitted from said electron beam source (41) is radiated onto a surface of a sample (47) so that reflected electrons (490) obtained from the surface of the sample (47) are subjected to energy analysis by said electron energy analyzer (49) (Fig. 4).

18. An electron beam application apparatus comprising a structure identical with that of at least one selected from electron beam sources (41) as defined in claim 1, and means for converging and radiating external electron beams (42) onto a multilayer consisting of said quantum well layer and said second material selectively in said structure, wherein the potential of said structure is changed so that electrons having specific energy among said electron beams are absorbed into said structure so as to be measured selectively (Fig. 9).

19. An electronic apparatus comprising: a structure which is identical with that of at least one selected from electron beam sources as defined in claim 1 and which has a tip shaped like a needle having a diameter of not larger than 500 nm; means for bringing said tip of the needle-shaped structure close to a distance of not larger than 10 nm from a surface of a sample; means for changing a potential of said needle-shaped structure relative to the surface of said sample; and means for measuring a change of a current flowing in said needle-shaped structure.

20. An electron beam source comprising a structure which has a double potential barrier type quantum well layer and in which the quantum well thus formed has a symmetric structure.

21. An electron beam source comprising a structure which has a double potential barrier type quantum well layer wherein said double potential barrier layer has a structure in which penetration lengths of electrons in respective potential barrier layers (12,31) are substantially coincident with each other.

22. An electron beam source comprising a structure which has a double potential barrier type quantum well layer wherein said double potential barrier layer has a structure in which said double potential barriers (12,31) control the thicknesses and heights of potential barriers and the effective mass of electrons so that penetration lengths of structures formed symmetrically with electrons with respective to the respective potential barrier layers are substantially coincident with each other.

# FIG. IA

# FIG. IB

# F I G. 2A

# F I G. 2B

# F I G. 3A

# F I G. 3B

# F I G. 4

F I G. 5A

F I G. 5B

F I G. 5C

F I G. 5D

F I G. 5E

FIG. 6A

FIG. 6B

FIG. 6C

FIG. 6D

FIG. 7A

71

72

73

FIG. 7B

74

75

# FIG. 8

# FIG. 9

# FIG. 10

# F I G. IIA

# F I G. IIB

# F I G. 12A

# F I G. 12B

21

**European Patent Office**

# EUROPEAN SEARCH REPORT

Application Number

EP 94 30 4816

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| Y | PATENT ABSTRACTS OF JAPAN vol. 17, no. 313 (E-1381) 15 June 1993 & JP-A-05 029 605 (SONY CORP.) 5 February 1993 * abstract * | 1-3,16, 20-22 | H01J1/30 H01J37/073 |
| Y | PATENT ABSTRACTS OF JAPAN vol. 12, no. 63 (E-585) 25 February 1988 & JP-A-62 205 658 (FUJITSU LTD.) 10 September 1987 * abstract * | 1-3,16, 20-22 | |
| A | IEEE TRANSACTIONS ON ELECTRON DEVICES, vol.38, no.10, October 1991, NEW YORK US pages 2337 - 2347 K.L. JENSEN ET AL. 'The methodology of simulating particle trajectories through tunneling structures using a Wigner distribution approach.' * abstract * | 1 | |
| A | JOURNAL OF VACUUM SCIENCE AND TECHNOLOGY: PART B., vol.11, no.2, April 1993, NEW YORK US pages 362 - 365 V.G. LITOVCHENKO ET AL. 'Field emission from structures with quantum wells' * the whole document * | 1,4-13 | TECHNICAL FIELDS SEARCHED (Int.Cl.6) H01J |
| D,A | PATENT ABSTRACTS OF JAPAN vol. 17, no. 393 (E-1402) 22 July 1993 & JP-A-05 074 333 (FUJITSU LTD) 26 March 1993 * abstract * | 1 | |

The present search report has been drawn up for all claims

| Place of search | Date of completion of the search | Examiner |
|---|---|---|
| THE HAGUE | 3 October 1994 | Schaub, G |